# FASCICULE DE BREVET EUROPEEN

(11) **EP 3 987 337 B1**
(45) Date de publication et mention de la délivrance du brevet: **31.07.2024**
(21) Numéro de dépôt: 20785788.9
(22) Date de dépôt: 19.06.2020
(51) Int. Cl.: H01L 33/58, H01S 5/00, H01S 5/02251, H01S 5/20, H01S 5/40, G02B 26/06, G02B 6/42

(54) **SOURCE LUMINEUSE COMPORTANT AU MOINS UNE PUCE A SEMI-CONDUCTEUR PORTANT AU MOINS UNE DIODE**
LICHTQUELLE MIT MINDESTENS EINEM HALBLEITERCHIP MIT MINDESTENS EINE DIODE
LIGHT SOURCE COMPRISING AT LEAST ONE SEMICONDUCTOR CHIP BEARING AT LEAST ONE DIODE

(30) Priorité: 21.06.2019 FR 1906718
(43) Date de publication de la demande: 27.04.2022
(73) Titulaire: Cailabs, 35200 Rennes (FR)
(72) Inventeur: PINEL, Olivier, 35000 RENNES (FR)
(74) Mandataire: IP Trust
(86) Numéro de dépôt international: PCT/FR2020/051076
(87) Numéro de publication internationale: WO 2020/254774

(56) Documents cités:
- US-A1- 2009 201 575
- US-B1- 9 566 751
- GALE M T ET AL: "DIRECT LASER WRITING OF PLANAR FRESNEL ELEMENTS FOR OPTICAL INTERCONNECTS", INSTITUTE OF PHYSICS CONFERENCE SERIES, IOP PUBLISHING, GB, no. 139, PART 02, 1 August 1994 (1994-08-01), pages 267 - 270, XP000669535, ISSN: 0951-3248
- YONGQI FU ET AL: "Investigation of single mode fiber coupling using diffractive optical element with continuous relief fabricated by focused ion beam technology", OPTICAL FIBER COMMUNICATION CONFERENCE. (OFC). TECHNICAL DIGEST POSTCONFERENCE EDITION. ANAHEIM, CA, MARCH 17 - 22, 2001; [TRENDS IN OPTICS AND PHOTONICS SERIES. TOPS. VOLUME 54], WASHINGTON, WA : OSA, US, 17 March 2001 (2001-03-17), pages ThC3_1 - ThC3_3, XP010545658, ISBN: 978-1-55752-655-7

## Description

### DOMAINE DE L'INVENTION

La présente invention concerne une source de lumière comportant une puce à semi-conducteurs portant au moins une diode.

### ARRIERE PLAN TECHNOLOGIQUE DE L'INVENTION

Une barrette de diodes laser forme une source laser de forte puissance à base de semi-conducteurs. Les diodes peuvent présenter une grande efficacité de conversion électro-optique, une forte puissance et elles sont arrangées linéairement ou matriciellement de manière très compacte. Les diodes laser de la barrette sont parfois désigné par l'expression « diodes lasers à rubans élargis » (ou « broad area laser diode » selon la terminologie anglo-saxonne généralement employée). Le rayonnement émis par ce type de diodes laser est par nature multi-mode, elles se distinguent donc bien des diodes laser à gain ou à indice guidé, dans lesquels on cherche à établir un rayonnement monomode.

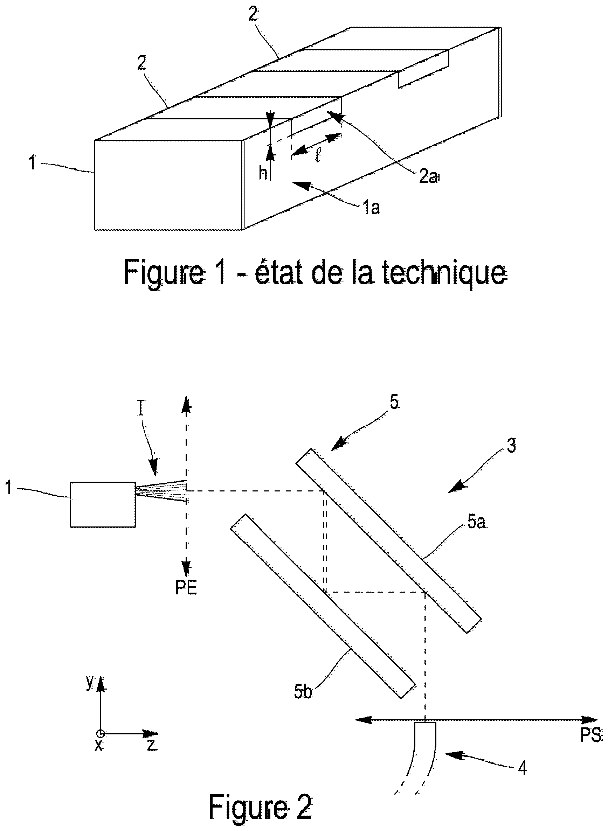

Une telle barrette est généralement composée d'une puce de semi-conducteurs, par exemple à base d'AsGa ou de GaN, portant les diodes laser agencées sur un substrat dissipateur de chaleur, parfois par l'intermédiaire d'une couche intercalaire. Des contacts électriques sont disposés sur la puce et sont reliés à des broches d'alimentation électrique de la barrette. On a ainsi représenté sur la figure 1 une vue schématique d'une puce à semi-conducteur 1 portant des diodes laser 2 de l'état de la technique. Les surfaces d'émission 2a des diodes 2 sont disposées sur une face principale 1a de la puce 1. Les surfaces d'émission 2a sont généralement étendues et présentent, comme cela est visible sur l'exemple de la figure 1, une largeur 1 typiquement de l'ordre de 100 µm ou plus et une dimension verticale h réduite, de l'ordre du micromètre.

Le rayonnement lumineux issu d'une telle barrette est donc constitué d'une pluralité de faisceaux alignés pour former un ruban d'émission. La dimension verticale h de chaque diode définit un axe dit rapide qui présente une divergence importante de l'ordre de 30 à 40° FWHM mais une bonne qualité de faisceau (facteur de qualité M2 du faisceau proche de un). La dimension horizontale L de chaque diode définit un axe dit lent, qui présente une divergence plus réduite, typiquement de l'ordre de 6° à 10°, mais une qualité de faisceau pauvre (facteur de qualité M2 du faisceau supérieur à 1000).

On prévoit donc généralement de conditionner le rayonnement produit par la barrette. Ce conditionnement peut être en partie intégré à celle-ci, par exemple sous la forme d'une lentille cylindrique disposée en vis-à-vis des surfaces d'émission 2a, de sorte à collimater le rayonnement émis selon la direction rapide au moins. On peut également prévoir des pièces optiques additionnelles à celle éventuellement intégrée à la barrette, de manière à mettre en forme le rayonnement lumineux. On peut ainsi rechercher à rendre le faisceau plus symétrique et/ou de meilleure qualité (comme mesurée par exemple par le paramètre M2) pour l'injecter dans une fibre optique conventionnelle, présentant un coeur essentiellement circulaire. D'une manière plus générale, on cherche à façonner le rayonnement lumineux émis par les diodes pour qu'il possède l'étendue optique la plus basse possible.

On connaît ainsi du document US5513201 un dispositif optique visant à réagencer le rayonnement émis par la barrette d'une première disposition selon laquelle les rayonnements émis par les diodes 2 sont disposés côte à côte, en juxtaposant leurs axes lents pour former un rayonnement en ruban, à une seconde disposition selon laquelle les rayonnements sont disposés côte à côte juxtaposés par leurs axes rapides. On rend de la sorte le rayonnement lumineux plus compact, ce qui facilite son injection dans une fibre optique.

Le document INJEYAN, Hagop et GOODNO, Gregory D. High power laser handbook. New York : McGraw-Hill Professional, 2011 fournit également de nombreux exemples d'agencements optiques visant à façonner le faisceau émis par une barrette de laser pour en faciliter le couplage avec une fibre optique. Il peut ainsi s'agir d'une mise en forme par un montage optique dit « de Southampton », par des miroirs étagés, ou par des pièces optiques réfractives tel que des micro prismes qui dévient le rayonnement de chaque diode laser dans des plans parallèles dans lesquels des micro lentilles sont disposées pour le collimater et former une matrice de faisceaux de petites dimensions. Dans tous les cas on cherche à injecter le faisceau ainsi façonné dans une fibre. On peut également prévoir d'intercaler une lentille sphérique pour faciliter cela.

Enfin, le document de « direct laser writing of planar fresnel éléments for optical interconnects » de 1994 et le document de Yongqi Fuz et al, "Investigation of single mode fiber coupling using diffractive optical élément with continuous relief fabricated by focused ion beam technology," OFC 2001. Optical Fiber Communication Conférence and Exhibit, Technical Digest Postconference Edition proposent de coupler les laser d'une barette à des fibres, par l'intermédiaire d'un bloc de lentilles formés par « quasi accord de phase par biréfringence de Fresnel » ou « Fresnel Phase Matching » Eléments (FPME).

Le document US 9 566 751 B1 propose un dispositif optique pour guider de la lumière vers un écran et le document US 2009/201575 A1 propose un dispositif permettant d'injecter dans un réseau de fibres ou une fibre multi coeur des impulsions optiques de fortes intensités.

Quelle que soit la solution choisie pour réaliser cette injection, on cherche bien entendu à injecter un maximum de la puissance optique émise par les diodes dans la fibre optique.

### OBJET DE L'INVENTION

Un but de l'invention est de proposer une solution originale à ce problème.

### BREVE DESCRIPTION DE L'INVENTION

En vue de la réalisation de ce but, l'objet de l'invention propose selon la revendication 1 une source de lumière comportant :
- au moins une puce à semi-conducteur apte à émettre un rayonnement incident mulitmode ;
- un étage de sortie comprenant au moins une fibre ou un espace libre pour propager une pluralité de modes prédéfinis;
- un dispositif de transformation modal disposé entre la puce à semi-conducteur et l'étage de sortie, le dispositif de transformation modal comprenant au moins une pièce optique (5) présentant une surface principale microstructurée disposée en vis-à-vis de la puce à semi-conducteur, le dispositif de transformation modal étant configuré pour intercepter le rayonnement incident au cours d'une pluralité de réflexion et/ou de transmission sur la pièce optique, chaque réflexion/ transmission sur la surface microstructurée étant suivie d'une propagation du rayonnement en espace libre, et la surface principale microstructurée configurée pour modifier spatialement la phase du rayonnement incident et former, par la pluralité de réflexion et/ou de transmission sur la pièce optique, un rayonnement lumineux transformé comprenant au moins les modes prédéfinis.

Selon d'autres caractéristiques avantageuses et non limitatives de l'invention, prises seules ou selon toute combinaison techniquement réalisable :
- la surface microstructurée est configurée pour décomposer le rayonnement incident selon une pluralité de modes d'entrée d'un plan d'entrée associée à une pluralité de modes de sortie définis dans un plan de sortie pour former le rayonnement transformé ;
- l'étage de sortie comprend au moins une fibre multimode ;
   1. le rayonnement lumineux transformé se couple à plus de 90% dans une extrémité d'injection de la fibre ;
- le rayonnement incident comprend un premier nombre de modes et la fibre multimode est apte à guider un deuxième nombre de modes, le deuxième nombre étant supérieur ou égal au premier ;
- l'étage de sortie est configuré pour permettre la propagation libre du rayonnement transformé ;
- le rayonnement incident émis par la puce à semi-conducteur est produit par une diode laser ou une diode électroluminescente ;
- le rayonnement incident émis par la puce à semi-conducteur est produit par une seule diode ;
- le rayonnement incident émis par la puce à semi-conducteur est produit par une pluralité de diodes émettant chacune un rayonnement multimode ou monomode ;
- la source de lumière comprend un dispositif de mise en forme du rayonnement incident, disposé entre la puce à semi-conducteur et la pièce optique ;
- le dispositif de mise en forme comprend une pluralité de fibres multimodes dans lesquels s'injectent respectivement des parties du rayonnements incident ;
- la microstructuration de la surface principale est à variables séparables.

### BREVE DESCRIPTION DES FIGURES

D'autres caractéristiques et avantages de l'invention ressortiront de la description détaillée de l'invention qui va suivre en référence aux figures annexées sur lesquels :
- La figure 1 représente une puce à semi-conducteur portant des diodes laser de l'état de la technique ;
- La figure 2 représente un exemple de source lumineuse reprenant les principes de l'invention ;
- Les figures 3a, 3b représentent respectivement un exemple de décomposition modale du rayonnement incident dans un plan d'entrée et du rayonnement transformé dans le plan de sortie ;
- La figure 4 représente un second exemple d'une source de lumière reprenant les principes de l'invention ;
- La figure 5 représente un autre exemple d'une source de lumière reprenant les principes de l'invention.

### DESCRIPTION DETAILLEE DE L'INVENTION

Par souci de clarté, on définit dans la présente demande un rayonnement lumineux comme un rayonnement formé d'au moins un mode du champ électromagnétique, chaque mode formant une distribution sspatio-fréquentielle de l'amplitude, de la phase, et de la polarisation du champ. En conséquence, le façonnage, la modification ou la transformation du rayonnement lumineux désigne la modification ou la transformation spatio-fréquentielle des modes du rayonnement.

On désignera par « forme » d'un rayonnement la distribution transverse de l'amplitude et de la phase du mode ou la combinaison des distributions transverses d'amplitude et de phase des modes composant ce rayonnement.

Par souci de simplification, on considérera dans la présente description que le rayonnement est polarisé selon une unique direction et présente une unique fréquence. Toutefois les principes exposés sont tout à fait applicables à un rayonnement présentant plus d'une direction de polarisation ou plus d'une unique fréquence.

On a représenté sur la figure 2, en vue de dessus, un exemple de source de lumière 3 reprenant les principes de l'invention.

Elle comprend une puce à semi-conducteur 1 comportant une pluralité de diodes laser, trois dans l'exemple représenté. On pourrait bien entendu prévoir un nombre différent de telles diodes, typiquement entre 1 et 100. Dans le cas où une unique diode laser est prévue, celle-ci émettra un rayonnement multimode pour pouvoir tirer profit d'un dispositif conforme à l'invention. Dans le cas où une pluralité de diodes sont prévues, elles peuvent indifféremment émettre un rayonnement monomode ou multimode. Dans le repère de la figure 2, la puce 1 est disposée pour que les surfaces d'émission des diodes laser soient toutes disposées le long de l'axe x, verticalement. On pourrait prévoir qu'elles soient arrangées différemment, selon une autre direction ou en matrice par exemple, cette matrice pouvant être obtenue en empilant les unes sur les autres une pluralité de puces à semi-conducteur similaires à celle représentée sur la figure 1. Bien que cela ne soit pas représenté sur la figure 2, la puce 1 peut être instrumentée d'une lentille de collimation ou d'une pluralité de telles lentilles, par exemple une lentille cylindrique mise en vis-à-vis des surfaces d'émission des diodes, d'un support dissipateur de chaleur et de tout autre élément utile pour constituer une barrette de diodes laser.

Quelle que soit la configuration choisie de la puce (ou des puces) à semi-conducteur 1, les diodes qu'elle porte émettent un rayonnement incident I. La source 3 représentée sur la figure 2 comprend également un étage de sortie 4, ici constituée d'une unique fibre optique multimode 4. Cette fibre présente une extrémité d'injection pour collecter le rayonnement lumineux émis par la puce à semi-conducteur 1 après que ce rayonnement a été mis en forme par les autres pièces optiques constituant la source 3 pour former un rayonnement transformé. L'étage de sortie peut comprendre une optique de collimation, non représentée sur la figure, pour favoriser la collecte du rayonnement transformé dans la fibre 4. D'une manière générale, on choisira la fibre (ou la pluralité de fibres) disposée à l'étage de sortie pour qu'elle puisse (collectivement) accommoder le nombre de modes composant le rayonnement incident I. Par exemple, si la puce à semi-conducteur 1 est composée de 5 diodes émettant chacune un rayonnement composé de 100 modes, on choisira une fibre multimode 4 (ou une collection de telles fibres) pouvant guider (collectivement) au moins les 500 modes composant le rayonnement incident I. Dit autrement, le rayonnement incident comprend un premier nombre de modes et la fibre multimode est apte à guider un deuxième nombre de modes, le deuxième nombre étant supérieur ou égal au premier nombre. On cherchera toutefois à limiter au maximum le nombre de modes de la (ou des) fibre multimode afin de ne pas augmenter excessivement le diamètre de la fibre et guider dans cette fibre un rayonnement présentant une forte concentration d'énergie.

La fibre ou la pluralité de fibres disposée dans l'étage de sortie peuvent être des fibres à gradient d'indice ou, préférentiellement, à saut d'indice.

On a également représenté sur la figure 2, un plan d'entrée PE et un plan de sortie PS, ces plans étant transverses respectivement au rayonnement incident I émis par les diodes et au rayonnement transformé s'injectant dans la fibre 4.

Pour permettre un couplage efficace du rayonnement incident I dans la fibre 4, la présente invention propose de traiter ce rayonnement incident modalement, c'est-à-dire opérer une conversion modale visant à transporter l'énergie du rayonnement incident respectivement présente dans des modes d'entrée vers des modes de sortie, ces modes de sortie étant adaptés pour se coupler efficacement avec la fibre 4.

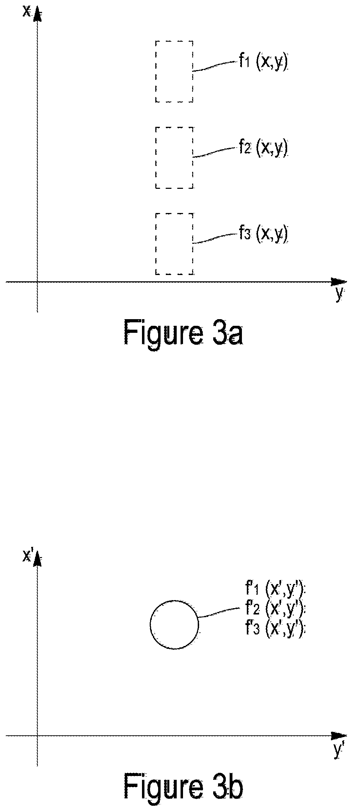

La figure 3a représente un exemple de décomposition modale dans le plan d'entrée PE du rayonnement émis par les diodes laser 2 qui s'est propagé jusqu'à ce plan d'entrée PE. Ce plan est muni d'un repère cartésien (x, y) dans lequel on peut décomposer modalement le rayonnement incident I, ici en trois modes f1(x,y), f2(x,y) et f3(x,y), les fonctions f1, f2 et f3 déterminant l'amplitude et la phase de chacun de ces modes. D'une manière générale, on déterminera le nombre et la nature des modes dans le plan d'entrée PE de manière à pouvoir décomposer aussi fidèlement que possible le rayonnement incident à ce plan PE. La famille des modes d'entrée peut notamment former une base.

On peut similairement décomposer le rayonnement transformé dans le plan de sortie PS à l'aide d'une famille de modes de sortie, dont la cardinalité est la même que celle de la famille d'entrée, et qui se couple au mieux à la fibre 4. Dans l'exemple représenté sur la figure 3b, le rayonnement transformé est formé des trois premiers modes LP f'1, f'2, f'3 centrés sur la fibre optique 4. Cette décomposition concorde avec les premiers modes LP guidés par la fibre multimode 4, ce qui permet de « remplir » convenablement ces modes guidées par le rayonnement transformé. On note que dans le cadre de la présente demande on cherche à injecter un maximum de puissance dans la fibre, et qu'il est indifférent que cette puissance soit injectée dans un mode guidé plutôt qu'un autre. A titre d'exemple, le rayonnement transformé se couple à plus de 90% dans une extrémité d'injection de la fibre multimode 4.

Entre le plan d'entrée et le plan de sortie, on a prévu un dispositf de tranformation modale, ici comprenant une première pièce optique 5a réfléchissante disposée en vis-à-vis d'une seconde pièce optique réfléchissante 5b, de sorte à définir une cavité multipassage dans lequel le rayonnement incident I se propage en direction de l'étage de sortie 4. La première pièce optique 5a présente une surface microstructurée qui intercepte le rayonnement lumineux incident I une pluralité de fois au cours de sa propagation. Chaque réflexion sur la surface microstructurée 5a modifie spatialement la phase de ce rayonnement, de sorte qu'à l'issue des multiples réflexions, le rayonnement incident est transformé pour se coupler à la fibre 4 formant dans cet exemple l'étage de sortie.

Par « surface microstructurée » on signifie que la surface de la pièce optique présente un relief, qui peut par exemple se décomposer sous la forme de « pixels » dont les dimensions sont comprises entre quelques microns à quelques centaines de microns. Le relief ou chaque pixel de ce relief présente une élévation variable par rapport à un plan moyen définissant la surface en question, d'au maximum quelques microns ou d'au maximum quelques centaines de microns. Une pièce optique présentant une telle surface microstructurée forme un masque de phase introduisant un déphasage local au sein de la section transverse du rayonnement qui s'y réfléchit ou qui s'y transmet.

La microstructuration de la première pièce est élaborée numériquement (à l'aide d'un logiciel de conception optique) pour permettre la transformation du rayonnement incident dans le rayonnement transformé apte à se coupler à la fibre 4. Dit autrement, la surface microstructurée est configurée pour associer, c'est-à-dire transformer, respectivement les modes d'entrée, tels qu'ils ont par exemple été définis sur la figure 3a, aux modes de sortie qui correspondent sensiblement à ceux guidés par les fibres, ici les trois premiers modes LP de la fibre. La surface microstructurée qui intercepte le rayonnement incident une pluralité de fois décompose le rayonnement selon les modes d'entrée qui sont transformés dans les modes de sorties pour former le rayonnement transformé. Pour poursuivre l'exemple représenté sur la figure 2, on pourra ainsi configurer la surface microstructurée pour transformer les modes d'entrée dans les modes de sortie, par exemple pour que le mode d'entrée f1 soit associé au mode de sortie f'1, le mode f2 soit associé au mode f'2, et le mode f3 soit associé au mode f'3. Toute transformation linéaire et unitaire entre les modes de sortie et les modes d'entrée est possible.

On trouvera dans les documents « Programmable unitary spatial mode manipulation », Morizur et Al, J. Opt. Soc. Am. A/Vol. 27, No. 11/November 2010 *;* N. Fontaine et Al, (ECOC, 2017),"Design of High Order Mode-Multiplexers using Multiplane Light Conversion"; US9250454 et US2017010463 les fondements théoriques et des exemples de mise en oeuvre pratique d'un tel dispositif de conversion modale.

Ainsi, un rayonnement lumineux qui se propage entre les pièces optiques 5a, 5b subit une succession de déphasages locaux séparés par des propagations. La succession de ces transformations élémentaires (par exemple au moins quatre transformations successives comme par exemple 8, 10, 12, 14, voire au moins 20 transformations) établit une transformation globale du profil spatial du rayonnement incident. Il est ainsi possible de configurer la surface microstructurée pour changer la forme du rayonnement incident I pour qu'il se couple avec efficacité avec la fibre 4 de l'étage de sortie.

Bien entendu, d'autres agencements optiques que la cavité multipassage formée par les pièces optiques réfléchissantes 5a, 5b sont possibles pour réaliser de dispositif de transformation modale souhaitée.

Ainsi, et plus généralement, la source de lumière 3 comprend au moins une pièce optique formant un dispositif de transformation modale 5 présentant une surface principale microstructurée disposée en vis-à-vis de la puce à semi-conducteur 1 pour intercepter le rayonnement incident I par une pluralité de réflexions/transmissions (par exemple au moins quatre réflexions/transmissions successives comme par exemple 8, 10, 12, 14, voire au moins 20 réflexions/transmissions) sur l'une ou les pièces optiques pour établir le rayonnement transformé. Chaque réflexion/transmission sur une surface microstructurée est suivie d'une propagation du rayonnement en espace libre. Certaines des pièces optiques peuvent être microstructurées et contribuer à former le rayonnement transformé, d'autres peuvent être simplement réfléchissantes ou transparentes pour guider ce rayonnement.

D'une manière générale, on cherche à limiter le nombre de réflexions et/ou transmissions sur les surfaces microstructurées du dispositif 5. Par exemple, on peut chercher à limiter ce nombre à moins de 20 ou moins de 10. On limite ainsi les pertes par absorption qui se produit à chaque réflexion et/ou transmission du rayonnement, on limite la complexité de conception du dispositif, c'est-à-dire la définition de la microstructuration de la surface ou des surfaces en jeu. Cela peut toutefois conduire à approximer avec moins de précision la transformation modale implémentée.

Aussi, pour simplifier le montage (c'est-à-dire le nombre de réflexions/transmissions), sa conception, ou pour rechercher une meilleure approximation de la transformation modale (pour un nombre de réflexions/transmissions fixé), on peut chercher à disposer les modes de la famille d'entrée et les modes de la famille de sortie pour que la transformation soit à variables séparables. Une telle transformation est décrite dans le document « Fabrication and Characterization of a Mode-selective 45-Mode Spatial Multiplexer based on Multi-Plane Light Conversion », Bade et al, Optical Fiber Communication Conférence Postdeadline Papers, OSA Technical Digest, Optical Society of America, 2018, paper Th4B.3, pp. 1-3 et la demande de brevet français FR1851664. Ces documents démontrent qu'une telle transformation permet une réduction du nombre de réflexions/transmissions constituant le dispositif de transformation modale 5.

Une famille de mode est dite à variables séparables lorsque pour chaque mode i,j de la famille on peut écrire fᵢⱼ(x,y)=hᵢ(x).gⱼ(y).

Dans les plan d'entrée PE et de sorties PS muni de leurs repères cartésiens respectifs (x,y) et (x',y'), on dispose d'une collection de N fonctions génératrices hi(x) et h'i(x') définis respectivement dans le plan d'entrée et dans le plan de sortie et d'une collection de M fonctions génératrices gⱼ(y) et g'ⱼ(y') également définis respectivement dans le plan d'entrée et dans le plan de sortie.

Ces fonctions génératrices sont exploitées pour définir les N*M modes d'entrées fᵢⱼ(x,y)=hᵢ(x).gⱼ(y) et N*M modes de sortie f'ᵢⱼ(x',y')=h'i(x').g'ⱼ(y') à variables séparables, 1<= i <= N et 1<= j <= M.

Pour tirer profit de la propriété de séparabilité des variables et simplifier la conception du dispositif de transformation modale 5, une transformation à variable séparable opérée par ce dispositif doit associer chaque mode de rang i,j du plan d'entrée au mode de même rang i,j dans le plan de sortie. En d'autres termes, pour tout couple (i,j), le mode fᵢⱼ(x,y)=hᵢ(x).gⱼ(y) du plan d'entrée est transformé par le dispositif 5 dans le mode f'ᵢⱼ(x',y')=h'ᵢ(x').g'ⱼ(y') du plan de sortie.

Une fois ces contraintes portant sur les familles de modes et sur leurs associations, on peut déployer une étape d'optimisation numérique conforme à l'état de la technique visant à établir les grandeurs de déphasage ϕₗ(x,y) (1<=1<=M, M dénotant le nombre de réflexion/transmission sur la pièce optique) de la surface microstructurée permettant de transformer au plus juste la famille de modes d'entrée en la famille de modes de sortie. Plus précisément, on cherche à établir les valeurs de phase ϕₗ(xₖ,yₖ) en tout pixel (xₖ,yₖ) de la surface de la pièce optique au niveau de chacun des M réflexions/transmissions. Ces déphasages peuvent être transformés aisément en une élévation de chaque pixel, ce qui permettra de fabriquer la surface microstructurée au niveau de chaque réflexion/transmission pour former M masques de phase. Chacun des M masques de phase présente la propriété d'être à variables séparables ou est proche de présenter cette propriété, c'est à dire que le déphasage ϕₗ(x,y) satisfait la relation ϕₗ(x,y)= ψₗ(x) + θₗ(y) où ψₗ et θₗ sont des fonctions génératrices de phase. En conséquence, la surface microstructurée (ou plus précisément la microstructuration de cette surface) présente également cette propriété, c'est à dire qu'au niveau de chaque réflexion/transmission, le relief ou l'élévation e de la microstructuration en un point (xₖ,yₖ) peut s'écrire sous une forme e(xₖ,yₖ)=u(xₖ)+v(yₖ), où u et v sont deux fonctions génératrices d'élévation.

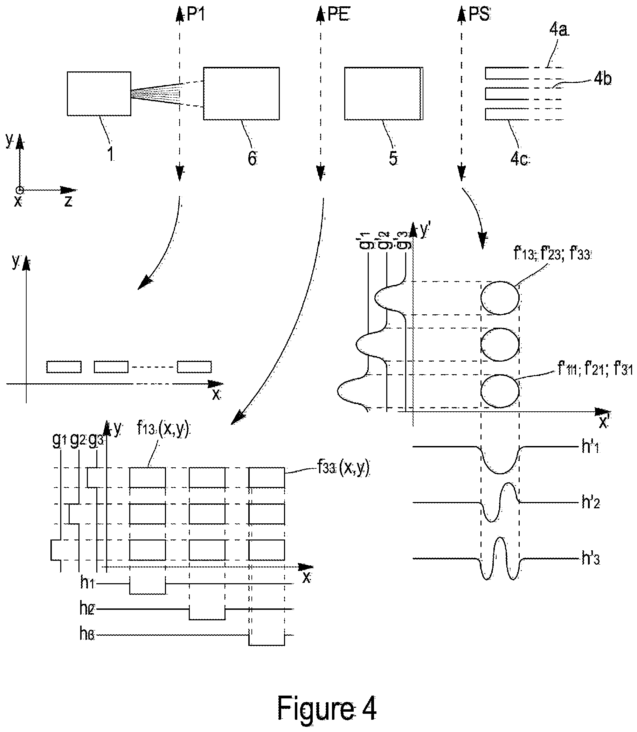

On a schématiquement représenté sur la figure 4 un exemple de source de lumière 3 mettant en oeuvre une telle transformation modale à variables séparables. On retrouve bien sur cette figure 4 la puce à semi-conducteur 1 comprenant ici 9 diodes lasers disposées linéairement selon l'axe x. La source laser 1 émet un rayonnement incident dont la distribution transverse dans un plan P1 est représentée schématiquement sur un premier insert de la figure 4. On observe bien la répartition linéaire des rayonnements issus de chaque diode de la puce à semi-conducteur 1.

Dans le montage de ce mode de mise en oeuvre, on a prévu un dispositif de mise en forme 6 du rayonnement incident I pour disposer ce rayonnement dans un plan d'entrée selon un agencement à variables séparables. Comme cela est bien visible sur le deuxième insert de la figure 4, les rayonnements émis par les diodes laser ont été réarrangés sous la forme d'une matrice. On définit de la sorte 9 modes d'entrée décrits par les fonctions f₁₁(x,y) à f₃₃(x,y), et on vérifie bien que chaque mode d'entré est le produit, dans le plan d'entrée PE, des fonctions génératrices h₁(x), h₂(x), h₃(x) et g₁(y), g₂(y), g₃(y). On note qu'un tel dispositif de mise en forme 6 est optionnel, notamment lorsque que le rayonnement incident I est naturellement décomposable par une famille de modes d'entrée à variable séparable (cas d'un arrangement en matrice des rayonnements émis par une pluralité de puces à semi-conducteur 1 empilés).

La source 3 représentée sur la figure 4 comprend également une un étage de sortie 4, ici composé d'un faisceau de trois fibres optiques multimodes 4a, 4b, 4c disposées dans un plan (y, z) dans le repère associé au montage. On note que le choix de placer trois fibres dans l'étage de sortie vise à montrer toute la versatilité de la solution, et on cherche généralement dans la pluspart des applications à injecter le rayonnement incident dans une unique fibre multimode pour y concentrer toute l'énergie. Le plan de sortie PS est muni d'un repère (x',y') cartésien et on a représenté sur le troisième insert de la figure 4, les 9 familles de modes de sortie f'₁₁(x',y') à f'₃₃(x',y'). Trois modes de cette famille sont respectivement associés à une fibre multimode, c'est-à-dire disposés spatialement en regard de l'extrémité d'injection de cette fibre. Ces trois modes sont donc spatialement superposés entre eux dans le plan de sortie PS.

Sur le troisième insert, on a également représenté les fonctions génératrices h'₁(x'), h'₂(x'), h'₃(x') et g'₁(y'), g'₂(y'), g'₃(y'). On vérifie bien, sur cet insert, que la caractéristique de séparabilité des variables est présente.

Le dispositif mettant en oeuvre la conversion modale 5 reprend les principes exposés en relation avec la description de la figure 2. La microstructuration de la surface ou des surfaces des pièces optiques qui composent le dispositif 5 a été configurée pour mettre en oeuvre la transformation modale associant chaque mode d'entrée de rang (i,j) au mode de sortie de même rang (i,j). En d'autres termes, et de manière très simplifiée et peu rigoureuse, les fonctions génératrices du plan d'entrée sont transformées dans les fonctions génératrices du plan de sortie. Cette relation assure une forme d'ordre de la transformation qui permet de grandement simplifier la conception du dispositif de transformation modale 5, par exemple en réduisant le nombre de réflexions/transmissions sur une surface microstructurée pour une précision donnée de la transformation.

Le dispositif de mise en forme 6 du rayonnement incident I peut être mis en oeuvre quant à lui de multiples manières. Il peut s'agir d'un dispositif de transformation modale similaire à celui du dispositif 5, mettant en oeuvre une pluralité de réflexions et/ou transmissions sur au moins une surface microstructurée, suivi de propagations libres. Dans ce cas, le dispositif de mise en forme 6 peut être physiquement séparé du dispositif de transformation modale 5, ou les deux dispositifs intégrés l'un à l'autre pour former un unique dispositif.

Dans une alternative, le dispositif de mise en forme 6 peut être mis en oeuvre par des pièces optiques plus conventionnelles. Il peut ainsi s'agir d'une pluralité de miroirs étagés captant chacun une partie du rayonnement émis par les diodes laser pour empiler ces parties les unes sur les autres et former la répartition en matrice de la figure 4. Dans une alternative encore, le dispositif de mise en forme 6 peut comprendre des pièces optiques réfractives tel que des micro prismes qui dévient le rayonnement de chaque diode laser dans des plans parallèles dans lesquels des micros lentilles sont disposées pour le collimater et former une matrice de faisceaux de petites dimensions.

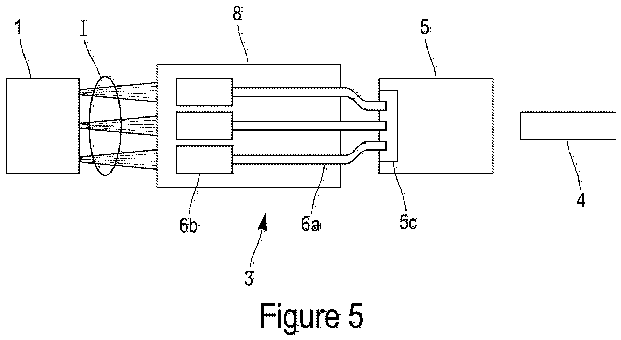

La figure 5 présente un autre exemple de mise en oeuvre de l'invention. La source de lumière 3 comprend un empilement de 3 puces à semiconducteurs 1, chaque puce comprenant ici une pluralité de diodes lasers disposées linéairement selon l'axe x. En conséquence, le rayonnement incident I est représenté sur la figure 5 comme une collection de 3 rayonnements élémentaires, chaque rayonnement élémentaire étant constitué du rayonnement émis par une pluralité de diodes laser.

On cherche à façonner ce rayonnement incident I pour faciliter l'injection d'un maximum de la puissance émise par l'empilement des puces 1 dans une fibre multimode 4. Pour cela on évite de traiter collectivement les rayonnements élémentaires, et au contraire on prévoit un dispositif de mise en forme 6 traitant séparément des parties du rayonnement incident. Le dispositif de mise en forme 6 est disposé entre les puces à semiconducteur 1 et le dispositif de transformation modale 5. Il comprend une pluralité de fibres multimodes 6a dans lesquels s'injectent respectivement, par une première extrémité de ces fibres, les rayonnements produits par des pluralités de diodes, par l'intermédiaire d'une pluralité de dispositif d'injection 6b. Ces dispositifs d'injection 6b peuvent mettre en oeuvre des pièces optiques conventionnelles (lentilles, mirroirs étagés, micro prismes... comme cela a été évoqué antérieurement) ou mettre en oeuvre un dispositif MPLC similaire au dispositif de transformation modale 5 déjà décrit. En traitant séparément des parties du rayonnement incident I pour les coupler respectivement à une pluralité de fibres optiques, on forme un meilleur couplage et on capture une plus grande quantité d'énergie que si l'on avait cherché à coupler le rayonnement incident entièrement dans une unique fibre.

Les autres extrémités des fibres multimodes 6a du dispositif de mise en forme 6 forment un étage d'éntrée 5c du dispositif de conversion modal 5. Comme dans les exemples précédent, celui-ci est configuré pour opérer une transformation du rayonnement produit par les fibres multimodes 6a visant à transporter son énergie dans les modes guidés de la fibre optique multimode 4.

Bien entendu l'invention n'est pas limitée aux modes de mise en oeuvre décrits et on peut y apporter des variantes de réalisation sans sortir du cadre de l'invention tel que défini par les revendications.

On peut ainsi prévoir que le dispositif de transformation modale 5 réalise des transformations plus complexes du rayonnement incident que ceux qui ont été décrits. On peut par exemple chercher à compenser optiquement par le dispositif 5 une éventuelle flèche de la puce semi-conductrice 1 selon la direction d'agencement des surfaces d'émission des diodes. Cette flèche dévie la forme en ruban du rayonnement d'une droite parfaite (forme en « smile » selon l'expression anglo-saxonne consacrée), ce qui n'est généralement pas souhaitable.

Par ailleurs, il n'est pas nécessaire que la source 1 comprenne un étage de sortie 4 constitué d'une ou d'une pluralité de fibres optiques. L'étage de sortie peut également permettre la propagation libre du rayonnement transformé par le dispositif de transformation modale 6. On cherchera toutefois dans tous les cas à ce que le rayonnement transformé par ce dispositif soit conformé à une pluralité de modes prédéfinis, que ceux-ci soient imposés par une fibre de l'étage de sortie ou choisis pour se propager librement. De plus l'étage de sortie 4 peut comprendre d'autres éléments tels que des lentilles ou d'autres pièces optiques que ceux qui ont été décrits dans les exemples particuliers de la présente description.

Enfin, l'invention n'est pas limitée à des diodes lasers à rubans élargis ni même à une puce à semi-conducteur laser, elle s'applique à toute source de lumière comprenant une puce à semi-conducteur apte à émettre un rayonnement lumineux multimode. La puce à semi-conducteur et la source peuvent notamment mettre en oeuvre au moins une diode électroluminescente.

L'invention trouve un intérêt particulier d'application dans le domaine des LIDAR ou pour la combinaison de lasers à cascade quantique.

## Revendications

1. Source de lumière (3) comportant :
- au moins une puce à semi-conducteur (1) apte à émettre un rayonnement incident multimode (I) ;
- un étage de sortie (4) comprenant au moins une fibre, ou un espace libre, pour propager une pluralité de modes prédéfinis;
- un dispositif de transformation modal disposé entre la puce à semi-conducteur (1) et l'étage de sortie (4), le dispositif de transformation modal comprenant au moins une pièce optique (5) présentant une surface principale microstructurée disposée en vis-à-vis de la puce à semi-conducteur (1), le dispositif de transformation modal étant configuré pour intercepter le rayonnement incident (I) au cours d'une pluralité de réflexion et/ou de transmission sur la pièce optique (5), chaque réflexion/transmission sur la surface microstructurée étant suivie d'une propagation du rayonnement en espace libre, et la surface principale microstructurée configurée pour modifier spatialement la phase du rayonnement incident (I) et former, par la pluralité de réflexion et/ou de transmission sur la pièce optique (5), un rayonnement lumineux transformé comprenant au moins les modes prédéfinis.

2. Source de lumière (3) selon la revendication précédente dans laquelle la surface microstructurée est configurée pour décomposer le rayonnement incident (I) selon une pluralité de modes d'entrée d'un plan d'entrée (PE) associée à une pluralité de modes de sortie définis dans un plan de sortie (PS) pour former le rayonnement transformé.

3. Source de lumière (3) selon l'une des revendications précédentes dans laquelle l'étage de sortie (4) comprend au moins une fibre multimode (4a, 4b, 4c).

4. Source de lumière (3) selon la revendication précédente dans laquelle le rayonnement lumineux transformé se couple à plus de 90% dans une extrémité d'injection de la fibre (4a, 4b, 4c).

5. Source de lumière (3) selon l'une des deux revendications précédentes dans lequel le rayonnement incident (I) comprend un premier nombre de modes et la fibre multimode est apte à guider un deuxième nombre de modes, le deuxième nombre étant supérieur ou égale au premier.

6. Source de lumière (3) selon l'une des revendications 1 à 2 dans lequel l'étage de sortie (4) est configuré pour permettre la propagation libre du rayonnement transformé.

7. Source de lumière (3) selon l'une des revendications précédentes dans laquelle le rayonnement incident multimode (I) émis par la puce à semi-conducteur (1) est produit par une diode laser ou une diode électroluminescente.

8. Source de lumière (3) selon la revendication précédente dans laquelle dans laquelle le rayonnement incident multimode (I) émis par la puce à semi-conducteur (1) est produit par une seule diode.

9. Source de lumière (3) selon la revendication 7 dans laquelle le rayonnement incident multimode (I) émis par la puce à semi-conducteur (1) est produit par une pluralité de diodes émettant chacune un rayonnement multimode ou monomode.

10. Source de lumière (3) selon l'une des revendications précédent comprenant un dispositif de mise en forme (6) du rayonnement incident, disposé entre la puce à semi-conducteur (1) et la pièce optique (5).

11. Source de lumière (3) selon la revendication précédente dans lequel le dispositif de mise en forme (6) comprend une pluralité de fibres multimodes dans lesquels s'injectent respectivement des parties du rayonnements incident.

12. Source de lumière (3) selon l'une des revendications précédentes dans lequel la microstructuration de la surface principale est à variables séparables.

## Patentansprüche

1. Lichtquelle (3), die aufweist:
- mindestens einen Halbleiterchip (1), der geeignet ist, eine einfallende Mehrmodenstrahlung (I) zu emittieren;
- eine Ausgangsstufe (4), umfassend mindestens eine Faser, oder einen freien Raum zum Verbreiten einer Vielzahl von vordefinierten Modi;
- eine Modaltransformationsvorrichtung, die zwischen dem Halbleiterchip (1) und der Ausgangsstufe (4) angeordnet ist, die Modaltransformationsvorrichtung umfassend mindestens ein optisches Teil (5), das eine mikrostrukturierte Hauptoberfläche vorweist, die gegenüber dem Halbleiterchip (1) angeordnet ist, wobei die Modaltransformationsvorrichtung zum Abfangen der einfallenden Strahlung (I) während einer Vielzahl von Reflexionen und/oder Transmissionen an dem optischen Teil (5) konfiguriert ist, wobei auf jede Reflexion/Transmission an der mikrostrukturierten Oberfläche eine Verbreitung der Strahlung in dem freien Raum folgt, und die mikrostrukturierte Hauptoberfläche zum räumlichen Modifizieren der Phase der einfallenden Strahlung (I) und Ausbilden, durch die Vielzahl von Reflexionen und/oder Transmissionen an dem optischen Teil (5), einer transformierten Lichtstrahlung konfiguriert ist, umfassend mindestens die vordefinierten Modi.

2. Lichtquelle (3) nach dem vorstehenden Anspruch, wobei die mikrostrukturierte Oberfläche zum Zerstreuen der einfallenden Strahlung (I) in eine Vielzahl von Eingangsmodi einer Eingangsebene (PE) konfiguriert ist, die mit einer Vielzahl von Ausgangsmodi verbunden ist, die in einer Ausgangsebene (PS) zum Ausbilden der transformierten Strahlung definiert sind.

3. Lichtquelle (3) nach einem der vorstehenden Ansprüche, wobei die Ausgangsstufe (4) mindestens eine Mehrmodenfaser (4a, 4b, 4c) umfasst.

4. Lichtquelle (3) nach dem vorstehenden Anspruch, wobei die transformierte Lichtstrahlung zu mehr als 90 % in ein Injektionsende der Faser (4a, 4b, 4c) gekoppelt wird.

5. Lichtquelle (3) nach einem der zwei vorstehenden Ansprüche, wobei die einfallende Strahlung (I) eine erste Anzahl von Modi umfasst und die Mehrmodenfaser geeignet ist, eine zweite Anzahl von Modi zu führen, wobei die zweite Anzahl größer als oder gleich der ersten Anzahl ist.

6. Lichtquelle (3) nach einem der Ansprüche 1 bis 2, wobei die Ausgangsstufe (4) zum Ermöglichen der freien Verbreitung der transformierten Strahlung konfiguriert ist.

7. Lichtquelle (3) nach einem der vorstehenden Ansprüche, wobei die einfallende Mehrmodenstrahlung (I), die durch den Halbleiterchip (1) emittiert wird, durch eine Laserdiode oder eine Leuchtdiode erzeugt wird.

8. Lichtquelle (3) nach dem vorstehenden Anspruch, wobei die einfallende Mehrmodenstrahlung (I), die durch den Halbleiterchip (1) emittiert wird, durch eine einzige Diode erzeugt wird.

9. Lichtquelle (3) nach Anspruch 7, wobei die einfallende Mehrmodenstrahlung (I), die durch den Halbleiterchip (1) emittiert wird, durch eine Vielzahl von Dioden erzeugt wird, die jeweils eine Mehrmoden- oder Einmodenstrahlung emittieren.

10. Lichtquelle (3) nach einem der vorstehenden Ansprüche, umfassend eine Vorrichtung (6) zum Formen der einfallenden Strahlung, die zwischen dem Halbleiterchip (1) und dem optischen Teil (5) angeordnet ist.

11. Lichtquelle (3) nach dem vorstehenden Anspruch, wobei die Formungsvorrichtung (6) eine Vielzahl von Mehrmodenfasern umfasst, in die jeweils Anteile der einfallenden Strahlung injiziert werden.

12. Lichtquelle (3) nach einem der vorstehenden Ansprüche, wobei die Mikrostrukturierung der Hauptoberfläche mit trennbaren Variablen erfolgt.

## Claims

1. Light source (3) comprising:
- at least one semiconductor chip (1) capable of emitting multi-mode incident radiation (I);
- an output stage (4) comprising at least one fiber or free space for propagating a plurality of predefined modes;
- a modal transformation device arranged between the semiconductor chip (1) and the output stage (4), the modal transformation device comprising at least one optical part (5) having a microstructured main surface arranged opposite the semiconductor chip (1), the modal transformation device being configured to intercept the incident radiation (I) during a plurality of instances of reflection and/or transmission on the optical part (5), each instance of reflection/transmission on the microstructured surface being followed by a propagation of the radiation in free space, and the microstructured main surface being configured to spatially modify the phase of the incident radiation (I) and to form, by the plurality of instances of reflection and/or transmission on the optical part (5), transformed light radiation comprising at least the predefined modes.

2. Light source (3) according to the preceding claim, wherein the microstructured surface is configured to decompose the incident radiation (I) according to a plurality of input modes of an input plane (PE) associated with a plurality of output modes defined in an output plane (PS) to form the transformed radiation.

3. Light source (3) according to either of the preceding claims, wherein the output stage (4) comprises at least one multi-mode fiber (4a, 4b, 4c).

4. Light source (3) according to the preceding claim, wherein more than 90% of the transformed light radiation is coupled into a feed end of the fiber (4a, 4b, 4c).

5. Light source (3) according to either of the two preceding claims, wherein the incident radiation (I) comprises a first number of modes and the multi-mode fiber is capable of guiding a second number of modes, the second number being greater than or equal to the first.

6. Light source (3) according to any of claims 1 to 2, wherein the output stage (4) is configured to allow the free propagation of the transformed radiation.

7. Light source (3) according to any of the preceding claims, wherein the multi-mode incident radiation (I) emitted by the semiconductor chip (1) is produced by a laser diode or a light-emitting diode.

8. Light source (3) according to the preceding claim, wherein the multi-mode incident radiation (I) emitted by the semiconductor chip (1) is produced by a single diode.

9. Light source (3) according to claim 7, wherein the multi-mode incident radiation (I) emitted by the semiconductor chip (1) is produced by a plurality of diodes each emitting multi-mode or single-mode radiation.

10. Light source (3) according to any of the preceding claims, comprising a shaping device (6) for shaping the incident radiation, arranged between the semiconductor chip (1) and the optical part (5).

11. Light source (3) according to the preceding claim, wherein the shaping device (6) comprises a plurality of multi-mode fibers into which parts of the incident radiation are respectively fed.

12. Light source (3) according to any of the preceding claims, wherein the microstructuring of the main surface takes place with separable variables.
